# EUROPÄISCHE PATENTSCHRIFT

(11) **EP 2 186 146 B1**
(45) Veröffentlichungstag und Bekanntmachung des Hinweises auf die Patenterteilung: **16.01.2013**
(21) Anmeldenummer: 08786837.8
(22) Anmeldetag: 04.08.2008
(51) Int. Cl.: H01L 41/053, F02M 51/06

(54) **PIEZOELEKTRISCHES AKTORMODUL**
PIEZOELECTRIC ACTUATOR MODULE
MODULE D'ACTIONNEUR PIÉZOÉLECTRIQUE

(30) Priorität: 09.08.2007 DE 102007037551
(43) Veröffentlichungstag der Anmeldung: 19.05.2010
(73) Patentinhaber: Robert Bosch GmbH, 70442 Stuttgart (DE)
(72) Erfinder: PREIBISCH, Joerg, 96215 Lichtenfels (DE); CROMME, Peter, 96050 Bamberg (DE); DE PAOLI, Albano, 75417 Muehlacker (DE); RAPP, Holger, 71254 Ditzingen (DE); KLOTZ, Claudia, 96047 Bamberg (DE); SOMMARIVA, Helmut, A-8053 Graz (AT); LANDVOGT, Robert, 96231 Staffelstein (DE)
(86) Internationale Anmeldenummer: PCT/EP2008/060224
(87) Internationale Veröffentlichungsnummer: WO 2009/019249

(56) Entgegenhaltungen:
- EP-A- 1 968 126
- EP-A1- 1 614 535
- DE-A1-102005 024 710
- DE-A1-102007 004 552
- DE-C1- 4 016 548
- JP-A- 1 137 686

## Beschreibung

### Stand der Technik

Die Erfindung betrifft ein piezoelektrisches Aktormodul für ein Brennstoffeinspritzventil und ein Brennstoffeinspritzventil mit solch einem piezoelektrischen Aktormodul. Speziell betrifft die Erfindung das Gebiet der Injektoren für Brennstoffeinspritzanlagen von luftverdichtenden, selbstzündenden Brennkraftmaschinen.

Aus der DE 102 17 361 A1 ist ein piezoelektrisches Element und eine mit diesem piezoelektrischem Element versehene Einspritzdüse bekannt. Das bekannte piezoelektrische Element umfasst eine Keramikaufschichtung, die abwechselnd übereinander gestapelt mehrere Keramikschichten aus piezoelektrischer Keramik und mehrere Innenelektrodenschichten enthält. Auf einem Teil der Oberfläche der Keramikaufschichtung ist eine organische Isolationsschicht aus organischem Material ausgebildet. Ferner ist auf der organischen Isolationsschicht eine anorganische Isolationsschicht aus anorganischem Material ausgebildet. Dabei hat die organische Isolationsschicht genügend Elastizität, um die Auslenkung des piezoelektrischen Elements zu absorbieren. Allerdings kann die organische Isolationsschicht den Feuchtigkeitsdurchgang nicht aktiv unterbinden und ist für Feuchtigkeit durchlässig. Allerdings unterbindet die anorganische Isolationsschicht den Feuchtigkeitsdurchgang, wobei die anorganische Isolationsschicht jedoch keine Elastizität hat.

Das aus der DE 102 17 361 A1 bekannte piezoelektrische Element und die mit diesem piezoelektrischen Element versehene Einspritzdüse haben den Nachteil, dass die Ausgestaltung relativ aufwändig ist. Ferner besteht das Problem, dass bei der Herstellung oder im Betrieb auftretende Öffnungen oder Risse in der anorganischen Tsolationsschicht ein Eindringen von Brennstoff in die organische Tsolationsschicht ermöglichen, wodurch es zu Kurzschlüssen zwischen den innenelektrodenschichten kommt.

JP 01 137686 A zeigt ein elektrisches Bauteil mit einer mehrlagigen Schutzschicht gegen Feuchtigkeit, wobei die Schichten organische Polymerfilme und Metallfilme aufweisen können.

EP 1968126 A2 zeigt einen Piezoaktor mit einer Schutzummantelung in Form eines mehrlagigen Schichtsystemverbands. Als innerste Schicht des Schichtsystemverbands ist ein polymerer Werkstoff vorgesehen. Eine darauffolgende Schicht ist aus isolierendem Kunststoff gebildet. Darüber ist eine zweite Schicht aus polymerem Werkstoff angeordnet Weiter folgen von innen nach außen eine erste Schicht aus einer metrischen Folie, eine dritte Schicht aus polymeren Werkstoff und eine zweite Schicht aus metallischer Folie.

DE 10 2005 024 710 A1 zeigt ein Brennstoffeinspritzventil mit einem piezoelektrischen Aktor, der von einem Dehnschlauch umgeben ist.

DE 40 16 548 C1 offenbart einen Klebstoff, der sich für die Verklebung von Ployimidfolien mit anderen Substraten, insbesondere Metallen in Form von Blechen oder Folien eignet

### Offenbarung der Erfindung

Das erfindungagemäße piezoelektrische Aktormodul mit den Merkmalen des Anspruchs 1 und das erfinungsgemäße Brennstoffeinspritzventil mit den Merkmalen des Anspruchs 10 haben den Vorteil, dass eine relativ kostengünstige Herstellung ermöglicht. ist, wobei ein zuverlässiger Schutz gegenüber Medien gewährleistet. ist., und dass insbesondere eine hohe Zuverlässigkeit und Funktionsfähigkeit gewährleistet ist.

Durch die in den Unteransprüchen aufgeführten Maßnahmen sind vorteilhäfte Weiterbildungen des im Anspruch 1 angegebenen piezoelektrischen Aktormoduls und des im Anspruch 10 angegebenen Brennstoffeinspritzventils möglich.

Vorteilhaft ist es, dass die Isolierfolie ein- oder mehrlagig um den mit der Grundschicht verschenen Aktorkörper gewickelt ist und dass die Metallfolie ein- oder mehrlagig um den mit der Isulierfolie umwickelten Aktorkörper gewickelt ist. Dabei kann der mit der Grundschicht versehene Aktorkörper in vorteilhafter Weise zunächst mit der isolierfolie mehrfach umwickelt werden, ohne dass eine stoffschlüssige Verbindung zwischen der isolierfolie und der Grundschicht besteht. Speziell ist kein Verbindungsmittel, insbesondere kein Klebstoff, vorgesehen, der die Isolierfolie mit dem Aktorkörper verbindet. Die Metallfolie kann dann mehrlagig um den mit der Isolierfolie umwickelten Aktorkörper gewickelt werden, wobei eine Klebstoffschicht zum Verbinden der Metallfolie mit der isolierfolie vorgesehen sein kann. Dadurch wird die Isolierfolie mittels der Metallfolie, die relativ steif ist, in ihrer Position gehalten und eine zusätzliche elektrische isolierung zwischen der Metallfolie und der Grundschicht erzielt. Dies hat den Vorteil, dass die Herstellung des piezoelektrischen Aktormoduls vereinfacht ist.

Durch die Isolierfolie ist. außerdem ein zuverlässiger Schutz gegenüber möglichen Kurzschüssen über die Metallfolie gebildet. Speziell kann es sich bei der Grundschicht um ein nicht ideal formbeständiges Material handeln, das beispielsweise durch das Umwickeln mit der Metallfolie plastisch verformt werden kann. Durch die Isolierfolie ist eine Berührung einer Außenfläche des Aktorkörpers mit der Metallfolie verhindert.

In vorteilhafter Weise ist die Isolierfolie auf der Basis zumindest eines Polypropylenaulfids und/oder zumindest eines Polyimids gebildet.

In vorteilhafter Weise ist eine Mehrschichtfolie vorgesehen, die die Isolierfolie und die Metallfolic aufweist, wobei die Mehrschichtfolie ein- oder mehrlaqiq um den mit der Grundschicht versehenen Aktorkörper gewickelt ist. Die Mehrschichtfolie erleichtert die Herstellung des piezoelektrischen Aktormoduls. Außerdem kann die Mehrschichtfolie so ausgestaltet werden, dass eine zuverlässige Fixierung der Isolierfolie mittels der mechanisch beanspruchbaren Metallfolie und ein zuverlässiger mechanischer Schutz der isolierfolie gewährleistet ist. Hierfür kann die Mehrschichtfolie insbesondere eine Binderschicht aufweisen, die zwischen der Isolierfolie und der Metallfolie vorgesehen ist und die die Metallfolie mit der Isolierfolie verbindet.

Ferner ist es vorteilhart, dass die Mehrschinhtfolie auf zumindest. einer Außenseite eine Klebstoffschicht aufweist, die eine zuverlässige Befestigung der Mehrschichtfolie an der Grundschicht ermöglicht und außerdem bei einem möglichen mehrlagigen Aufbau, das heißt einer mehrlagigen Umwicklung mit der Mehrschichtfolie, eine verklebung der einzelnen, übereinanderliegenden Lagen der Mehrschichtfolie und somit eine hohe mechanische Stabilität gewährleistet.

Erfindungsgemäß weist die Metallfolie eine zumindest im Wesentlichen Parallelogramm-förmige Geometrie auf, die beim Umwickeln des Aktorkörpers eine spiralförmige Umwicklung erzeugt. Ferner weist die Metallfolie erfindungsgemäß eine zumindest im Wesentlichen Doppe-parallelogramm-förmige Geometrie auf, so dass bei der Umwicklung zwei sich gegensinnig spiralförmig gewickelte Umwicklungen erzeugt werden. Dabei sind auch gewisse Abweichungen von der idealen Parallelogramm-förmigen Geometrie oder der idealen Doppelparallelogramm-förmigen Geometrie möglich, die ebenfalls zu einer spiralförmigen Umwicklung beziehungsweise zu zwei gegensinnig spiralförmig gewickelten Umwicklungen führen. Diese Ausgestaltungen haben den Vorteil, dass eine zusätzliche Elastizität der Urnwicklung erzielt ist. Dies ist, beispielsweise bei einem Aktormodul, das mehrere Aktorkörper und gegebenfalls ein oder mehrere Zwischenstücke aufweist, wodurch eine relativ lange Bauform vorgegeben ist., von Vorteil. Außerdem wird bei einer solchen langen Bauform die Herstellung den piezoelektrischen Aktormoduls erleichtert.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt.:
- Fig. 1: ein Brennstoffeinspritzventil mit einem piezoelektrischen Aktormodul in einer schematischen Schnittdarstellung
- Fig. 2: zeigt einen Schnitt durch das in der Fig. 1 dargesteille Aktormodul des Brennstoffeinspritzventils entlang der mit. It bezeichneten Schnittlinie;
- Fig. 3: den in Fig. 2 dargestellten Ausschnitt entsprechend einer modifizierten Ausführung;
- Fig. 4: den in Fig. 3 mit. IV bezeichneten Ausschnitt in einer detaillierten Darstellung;
- Fig. 5: eine eiste erfindungsgemäße geometrische Form für eine Metallfolie und/oder eine Mehrschichtfolie eines piezoelektrischen Aktormoduls entsprechend einem Ausührungsbeispiel der Erfindung und
- Fig. 6: eine zweite erfindungsgemäße geometrische Form für eine Metallfolie und/oder eine Mehrschichtfolie eines piezoelektrischen Aktors entsprechend einem weiteren Ausführungsbeispiel der Erfindung.

### Ausführungsformen der Erfindung

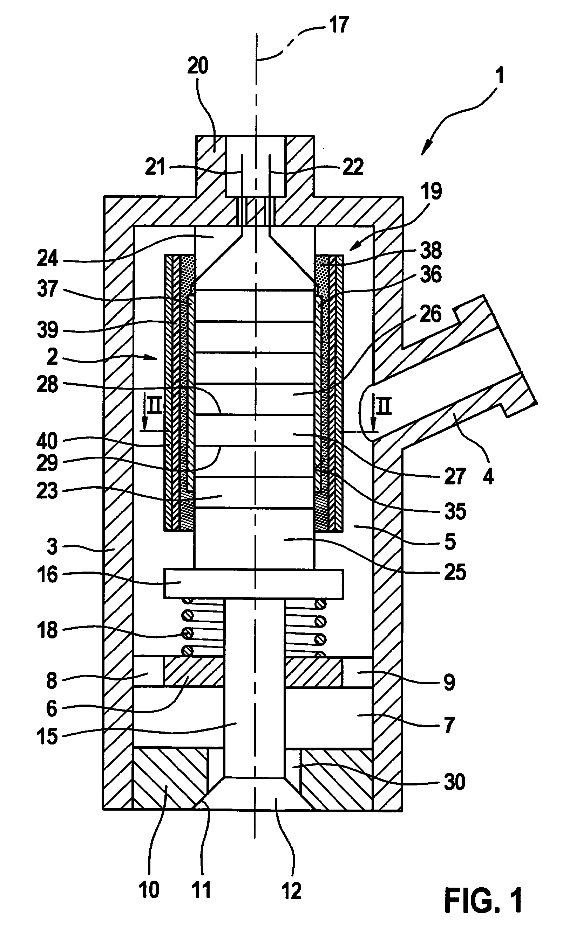

Fig. 1 zeigt: ein Brennstoffeinspritzventil mit einem piezoelektrischen Aktor 2. Das Brennstoffeinspritzventil 1 kann insbesondere als Injektor für Brennstoffeinspritzan-angen von luftverdichtenden, selbstzündenden Brennkraftmaschinen dienen. Ein bevorzugter Einsatz des Brennstoffeinspritzventils 1 besteht. für eine Brennstoffeinspritzanlage mit einem Common-Rail, das Dieselbrennstoff unter hohem Druck zu mehreren Brennstoffeinspritzventilen 1 führt. Der piezoelektrische Aktor 2 eignet sich besonders für solch ein Brennstoffeinspritzventil 1 und auch für eine inverse Ansteuerung des piezoelektrischen Aktors 2. Das Brennstoffeinspritzventil 1 und der piezoelektrische Aktor 2 eignen sich jedoch auch für andere Anwendungsfälle.

Das Brennstoffeinspritzventil 1 weist. ein Ventilgehäuse 3 und einen mit. dem Ventilgehäuse 3 verbundenen Brennstoffeinlassstutzen 4 auf. An den Brennstoffeinlassstutzen 4 ist. eine Brennstoffleitung anschließbar, um das Brennstoffeinspritzventil 1 über ein Common-Rail oder direkt mit einer Hochdruckpumpe zu verbinden. Über den Brennstoffeinlassstutzen 4 kann dann Brennstoff in einen im Inneren des Ventilgehäuses 3 vorgesehenen Aktorraum 5 eingeleitet werden, so dass sich im Betrieb des Brennstoffeinspritzventils 1 Brennstoff in dem Aktorraum 5, in dem auch der piezoelektrische Aktor 2 vorgesehen ist, befindet. Der Aktorraum 5 ist durch ein Gehäuseteil 6 von einem ebenfalls im Inneren des Ventilgehäuses 3 vorgesehenen Brennstoffraum 7 getrennt. In dem Gehäuseteil 6 sind dabei Durchlassöffnungen 8, 9 ausgestaltet, um den über den Brennstoffeinlassstutzen 4 in den Aktorraum 5 geführten Brennstoff in den Brennstoffraum 7 zu leiten.

Das Ventilgehäuse 3 ist mit einem Ventilsitzkörper 10 verbunden, an dem eine Ventilsitzfläche 11 ausgebildet ist. Die Ventilsitzfläche 11 wirkt mit einem Ventilschließkörper 12 zu einem Dichtsitz zusammen. Dabei ist der Ventilschließkörper 12 einstückig mit einer Ventilnadel 15 ausgebildet, über die der Ventilschließkörper 12 mit einer im Aktorraum 5 vorgesehenen Druckplatte 16 verbunden ist. Dabei ist die Ventilnadel 15 durch das Gehäuseteil 6 entlang einer Achse 17 des Brennstoffeinspritzventils 1 geführt. Ein Federelement 18, das einerseits an dem Gehäuseteil 6 und andererseits an der Druckplatte 16 anliegt, beaufschlagt den piezoelektrischen Aktor 2 mit einer Vorspannkraft, wobei durch die Beaufschlagung außerdem die Ventilnadel 15 mittels der Druckplatte 16 betätigt wird, so dass der zwischen dem Ventilschließkörper 12 und der Ventilsitzfläche 11 gebildete Dichtsitz geschlossen ist.

Außerdem weist das Ventilgehäuse 3 ein Anschlusselement 20 auf, um das Anschließen einer elektrischen Zuleitung an das Brennstoffeinspritzventil 1 zu ermöglichen. Die elektrische Zuleitung kann dabei mittels eines Steckers an elektrische Leitungen 21, 22 angeschlossen werden. Die elektrischen Leitungen 21, 22 sind durch das Gehäuse 3 und einen an einen Aktorkörper 23 des Aktors 2 angefügten Aktorfuß 24 an den Aktorkörper 23 geführt. An den Aktorkörper 23 des piezoelektrischen Aktors 2 ist ferner ein Aktorkopf 25 angefügt, über den der Aktorkörper 23 entgegen der Kraft des Federelements 18 auf die Druckplatte 16 einwirkt. Der piezoelektrische Aktor 2 weist in dem dargestellten Ausführungsbeispiel den Aktorkörper 23, den Aktorfuß 24 und den Aktorkopf 25 auf, so dass ein Aktormodul 19 gebildet ist.

Das Aktormodul kann aus zwei oder mehr Aktorkörpern 23 aufgebaut sein. Dabei können zwischen den einzelnen Aktorkörpern 23 Zwischenstücke vorgesehen sein oder die einzelnen Aktorkörper 23 können auch an ihren Stirnflächen miteinander verklebt werden.

Der Aktorkörper 23 des piezoelektrischen Aktors 2 weist eine Vielzahl von keramischen Schichten 26, 27 und eine Vielzahl von zwischen den keramischen Schichten 26, 27 angeordneten Elektrodenschichten 28, 29 auf. Dabei sind in der Fig. 1 zur Vereinfachung der Darstellung nur die keramischen Schichten 26, 27 sowie die Elektrodenschichten 28, 29 gekennzeichnet. Die Elektrodenschichten 28, 29 sind abwechselnd mit der elektrischen Leitung 21 und der elektrischen Leitung 22 verbunden, so dass alternierend positive und negative Elektroden zwischen den keramischen Schichten 26, 27 vorgesehen sind.

Über die elektrischen Leitungen 21, 22 kann der piezoelektrische Aktor 2 geladen werden, wobei sich dieser in Richtung der Achse 17 ausdehnt, so dass der zwischen dem Ventilschließkörper 12 und der Ventilsitzfläche 11 ausgebildete Dichtsitz geöffnet wird. Dadurch kommt es zum Abspritzen von Brennstoff aus dem Brennstoffraum 7 über einen Ringspalt 30 und den geöffneten Dichtsitz. Beim Entladen des piezoelektrischen Aktors 2 zieht sich dieser wieder zusammen, so dass der zwischen dem Ventilschließkörper 12 und der Ventilsitzfläche 11 ausgebildete Dichtsitz wieder geschlossen ist.

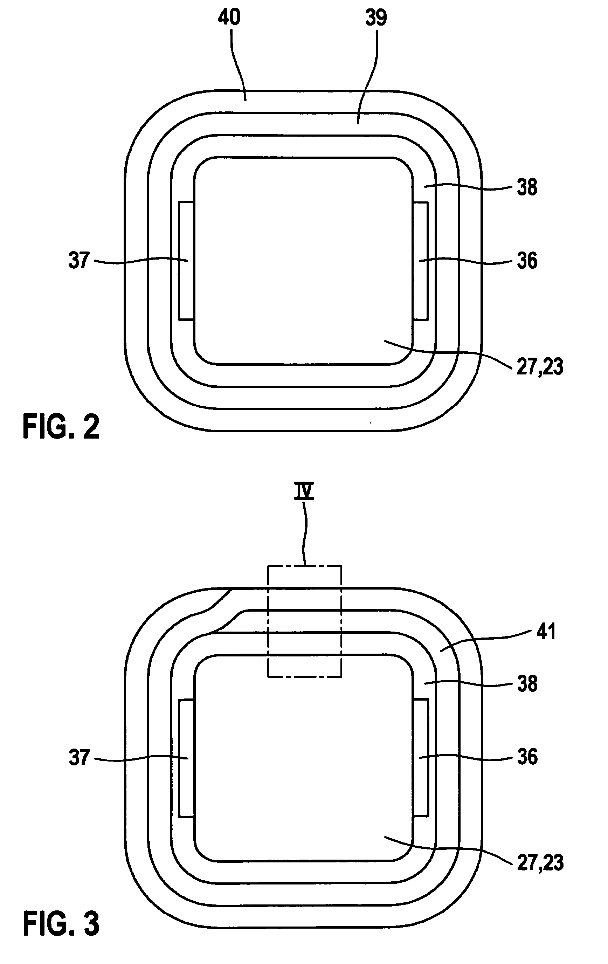

Die weitere Ausgestaltung des Aktormoduls 19 mit dem piezoelektrischen Aktor 2 des Brennstoffeinspritzventils 1 ist anhand der Fig. 1 und 2 im Detail weiter beschrieben. Auf der Außenfläche 35 des Aktorkörpers 23 des Aktormoduls 19 sind Außenelektroden 36, 37 vorgesehen, die mit den elektrischen Leitungen 21, 22 verbunden sind. In der dargestellten Ausführung sind die Elektrodenschichten 28, 29 daher über Außenelektroden 36, 37 alternierend mit den elektrischen Leitungen 21, 22 verbunden. Es ist allerdings auch möglich, dass eine oder beide Außenelektroden 36 oder 37 als innenliegende Elektroden ausgestaltet sind.

Auf die Außenfläche 35 des Aktorkörpers 23 ist, außerdem eine Grundschicht 38 aufgebracht, die im Bereich der Außenelektroden 36, 37 auch die Außenelektroden 36, 37 überdeckt. Die Grundschicht 38 erstreckt sich außerdem auch zumindest teilweise auf den Aktorfuß 24 sowie den Aktorkopf 25. Die Grundschicht 38 gewährleistet eine elektrische Durchschlagsfestigkeit zwischen den einzelnen Elektrodenschichlen 28, 29. Ferner dichtet die Grundschicht 38 die Außenfläche 35 des Aktorkörpers 23 gegunüber der Umgebung, insbesondere gegenüber im Aktorraum 5 vorgesehenen Brennstoff, ab. Die Grundschicht 38 ist. dabei elastisch ausgestaltet, um den Dehnungen des Aktorkörpers 23 im Betrieb zu folgen, so dass es insbesondere nicht zum Reißen der Grundschicht 38 kommt. Die Grundschicht 38 kann beispielsweise auf der Basis eines Silikonelastomers oder eines Perfluorethers gebildet sein oder als Lack auf die Außenfläche 35 aufgebrachht. werden.

Das piezoelektrische Aktormodul 19 weist außerdem eine elektrisch isolierende Isolierfolie 39 auf, die vorzugsweise mehrlagig um den mit der Grundschicht 38 versehenen Aktorkörper 23 sowie die teilweise mit der Grundschicht 38 versehenen Übergangsstücke, das heißt den Aktorkopf 25 und den Aktorfuß 24, gewickelt ist. Die Isolierfolie 39 kann dabei mittels einer Klebstotfschicht mit der Grandschicht. 38 verbunden werden.

Um den mit der Isolierfolie umgebenen Aktorkörper 23 sowie die beiden Übergangsstücke, das heißt den Aktorfuß 24 und den Aktorkopf 25, ist ferner eine Metallfolie 40 gewickelt. Die Isolierfolie 39 ist. vorzugsweise mittels einer Klebstoffschicht mit der Metallfolie 40 verbunden, wobei in diesem Fall die Isolierfolie 39 auch ohne eine Klebstoffschicht oder dergleichen um den mit der Grundschicht 38 vorschenen Akterkörper 23 gewischelt sein kann. Die mechanische Stabilität der Isolierfolie 39 ist dabei durch die relativ steife Metallfolie 40 gewährleistet.

Die Isolierfolie 39 gewährleistet, dass ein Kontakt der Metallfolie 40 mit dem Aktorkörper 23 und somit ein Kurzschluss zwischen den Elektrodenschichten 28, 29 verhindert ist. Beispielsweise besteht die Gefahr, dass sich die Grundschicht 38 durch die mechanische Kräfte, die beim Umwickeln mit der Metallfolie 40 auftreten, plastisch verformt. Die elektrisch isolierende Isolierfolie 39 hat somit auch den Vorteil, dass die Anforderungen an die Grundschicht 38 reduziert sind und eine größere Auswahl hinsichtlich möglicher Materialien für die Grundschicht 38 ermöglicht wird. Das Umwickeln der Grundschicht 38 mit der Isolierfolie 39 und der Metallfolie 40 erfolgt vorzugsweise nach einem Aushärten der Grundschicht 38. Die Metallfolie 40 stellt einen hohen mechanischen und chemischen Widerstand gegenüber Einflüssen auf die Grundschicht 38 dar, so dass die Anforderungen an die Grundschicht 38 hinsichtlich der Medien- und mechanischen Beständigkeit reduziert sind. Die Metallfolie 40 ist vorzugsweise aus Aluminium oder einem rostfreien Edelstahl gebildet.

Ferner verhindert die Isolierfolie 39 einen Kurzschluss zwischen der Metallfolie 40 und den Außenelektroden 36, 37. Außerdem sorgt die Isolierfolie 39 dafür, dass kein elektrischer Kontakt zwischen der Metallfolie 40 und gegebenenfalls metallisch ausgestalteten Anbauteilen, insbesondere dem Aktorfuß 24 und dem Aktorkopf 25, entsteht, so dass eine Reduzierung der Koppelkapazität des Aktors 2 verhindert ist.

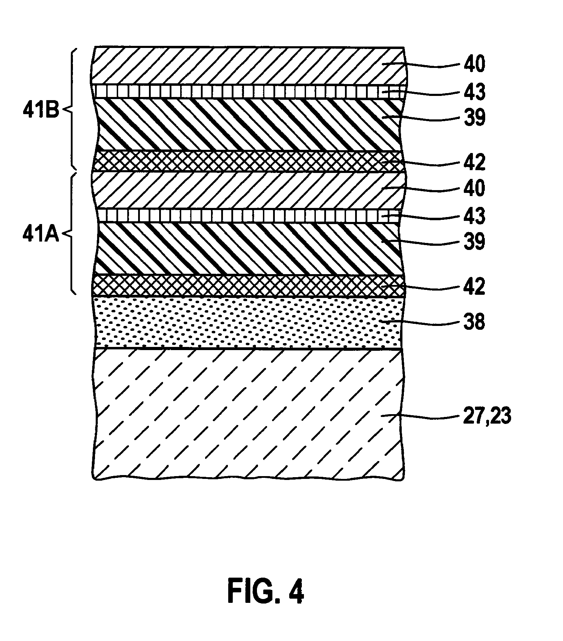

Fig. 3 zeigt den in Fig. 2 dargestellten Ausschnitt eines piezoelektrischen Aktors 2 eines Aktormoduls 19 entsprechend einer modifizierten Ausführung. In dieser Ausführungsfrom ist der mit den Außenelektroden 36, 37 versehene Aktorkörper 23 mie in Fig. 2 mit einer Grundschicht 38 umgeben. Ferner ist eine Mehrschichtfolie 41 vorgesehen, die die Isolierfolie 39 und die Metallfolie 40 umfasst. Die Mehrschichtfolie 41 ist in der dargestellten Ausführung zweifach um den Aktorkörper 23 gewickelt, so dass sich eine zweilagige Umwicklung ergibt. Die Mehrschichtfolie 41 ist vorzugsweise mit der Isolierfolie 39 verbunden. Ferner sind auch die einzelnen Lagen der Mehrschichtfolie 41 miteinander verbunden. Die Mehrschichtfolie 41 kann mit relativ geringem Aufwand um den Aktorkörper 23 gewickelt werden. Der Aufbau der Mehrschichtfolie 41 ist anhand der Fig. 4 in weiterem Detail beschrieben.

Fig. 4 zeigt den in Fig. 3 mit IV bezeichneten Ausschnitt des piezoelektrischen Aktormoduls 19 in einer schematischen Schnittdarstellung. Die Mehrschichtfolie 41 weist die Lagen 41A und 41B auf. Die Metallfolie 40 umfasst aufeinanderfolgend eine Klebstoffschicht 42, die Isolierfolie 39, eine Binderschicht 43 und die Metallfolie 40. Dabei ist die Isolierfolie 39 der Lage 41A über die **Klebstoffschicht** 42 mit der Grundschicht 38 verbunden. Ferner ist innerhalb der Mehrschichtfolie 41 die Metallfolie 40 über die Binderschicht 43 mit der Isolierfolie 39 verbunden. Die Isolierfolie 39 der Lage 41B ist über die Klebstoffschicht 42 mit der Metallfolie 40 der Lage 41A verbunden. Somit ergibt sich eine hohe mechanische Festigkeit des Aufbaus der Aktormoduls 19 mit der Mehrschichtfolie 41.

Es ist anzumerken, dass die Binderschicht 43 swischen der Isolierfolie 39 und der Metallfolie 40 auch entfallen kann. Ferner kann auch die Klebsteffschicht 42 entfallen.

Die Metallfolie 40 kann auch mit einem Lack, einem Silikonelastomer oder einem Perfluorether getränkt werden, um eine vorteilhafte Anbindung zu erreichen. Dabei kann für die Anbindung dasselbe Material wie für die Grundschicht 38 zum Einsatz kommen. Das Tränken der Metallfolie 40 kann dabei nach dem Aufwickeln erfolgen. Alternativ kann das Bindermaterial auch vor dem Aufwickeln auf die Metallfolie 40 aufgebracht werden, beispielsweise durch Aufrakeln, wie es beispielsweise anhand der Binderschicht 43 der Mehrschichtfolie 41 beschrieben ist.

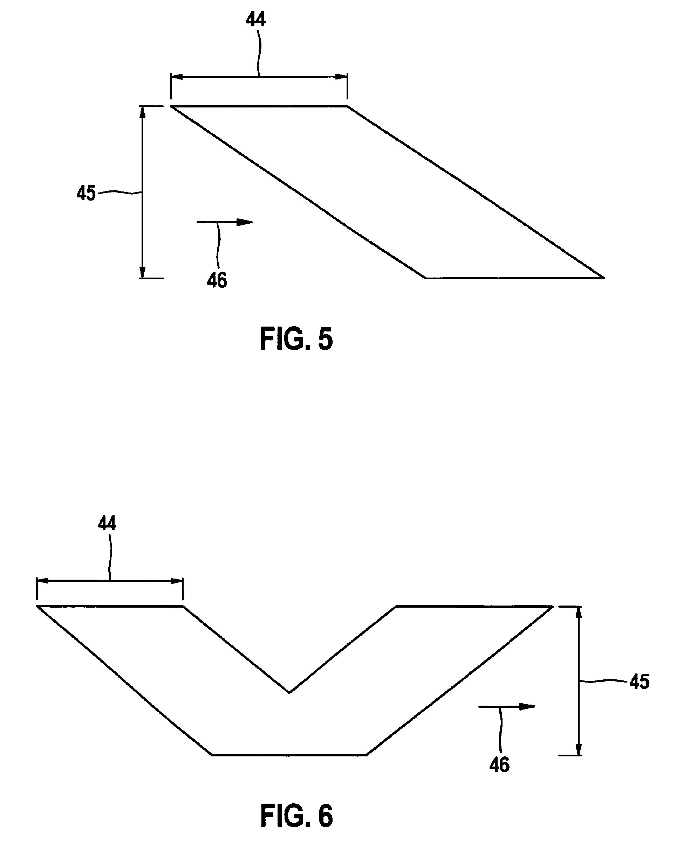

Fig. 5 zeigt eine erste erfindungsgemäße Parallelogramm-förmige Geometrie für die die Metallfolie 40 und/oder die Mehrschichtfolie 41 entsprechend einem Ausfuhrungsbeispiel der Erfindung. Diese und weitere Geometrien sind im Folgenden anhand der Mehrschichtfolie 41 exemplarisch beschrieben. Bei dem in der Fig. 5 dargestellten erfindungsgemäß Ausführungsbeispiel ist eine Seitenlänge 44 des Parallelogramms größer als der Umfang des Aklorkörpers 23 gewählt. Eine Höhe 45 des Parallelogramms ist größer als die Einbaulänge des Aktormoduls 19 gewählt. Eine Wickelrichtung 46 bei der Montage des Aklormoduls 19 ist vorzugsweise parallel zu der Seiltenlänge 44 gewählt. Dadurch ergibt sich eine spiralförmige Umwicklung des Aktorkörpers 23 sowie des Aktorkopfes 25 und des Aktorfußes 24. Dies ist insbesondere bei relativ großen Einbaulängen dies Aktormoduls 19 von Vorteil.

Eine zweite erfindungsgemäße Geometric der Metallfolie 40 ist anhand der Fig. 6 dargestellt, die ein weiteres Ausfhrungsbeispiel, der Erfindung zeigt. Die Geometrie der Metallfolie 40 dieses Ausführungsbeispiels ist in Form eines Doppelparallelogramms gewählt, bei dem zwei gegensinnig spiralförmig gewickelte Schichten entstehen. Dabei ist die Seitenlänge 44 des Dopppelparallelogramms größer als der Aktorumfang gewählt. Außerdem ist. die Höhe 45 größer als die Länge des Aktorkörpers 23 gewählt. Die Wickelrichtung 46 ist. vorzugsweise parallel zu der Seitenlänge 44 gewählt.

Die Erfindung ist nicht auf die beschriebenen Ausführungsbeispiele beschränkt.

## Patentansprüche

1. Piezoelektrisches Aktormodul (19), insbesondere Aktormodul für Brennstoffeinspritzventile, mit zumindest einem Aktorkörper (23), der eine Vielzahl von keramischen Schichten (26, 27) und eine Vielzahl von zwischen den keramischen Schichten (26, 27) angeordneten Elektrodenschichten (28, 29) aufweist, wobei eine Grundschicht (38) zumindest im Wesentlichen eine Außenfläche (35) des Äktorkörpers (23) umgibt, eine Metallfolie (40) um den mit der Grundschicht (38) versehenen Aktorkörper (23) gewickelt ist, und die Grundschicht (38) und die Metallfolie (40) durch zumindest eine Isolierfolie (39) voneinander getrennt sind, dadurch gekennzeichet, dass die Metallfolie (40) eine zumindest im Wesentlichen Parallelogramm-förmige Geometrie oder eine zumindest im Wesentlichen Doppelparallelogramm-förmige Geometrie aufweist.

2. Piezoclektrisches Aktormoduls (19) nach Anspruch 1,
**dadurch gekennzeichnet,**
**dass** die Isolierfolie (39) zumindest einlagig um den mit der Grundschicht (38) versehenen Aktorkörper (23) gewickelt ist und dass die Metallfolie (40) zumindest einlagig um den mit der Isolierfolie (39) umwickelten Aktorkörper (23) gewickelt ist.

3. Piezoelektrisches Aktormodul nach Anspruch 2,
**dadurch gekennzeichnet,**
**dass** die Isolierfolie (39) mittels einer Klebstoffschicht (42) mit der Metallfolie (40) verbunden ist.

4. Piezoelektrisches Aktormodul nach Anspruch 3,
**dadurch gekennzeichnet,**
**dass** die Isolierfolie (39) unmiltelbar um den mit der Grundschicht (38) versehenen Aktorkörper (23) gelegt ist.

5. Piezoelektrisches Aktormodul nach Anspruch 3 order 4,
**dadurch gekennzeichnet,**
**dass** keine stoffschlüssige Verbindung zwischen der Isolierfolie (39) und der Grundschicht (38) besteht.

6. Piezoelektrisches Aktormodul nach Anspruch 1,
**dadurch gekennzeichnet,**
**dass** eine Mehrschichtfolie (41) vorgesehen ist, die die Isolierfolie (39) und die Metallfolie (40) aufweist, und dass die Mehrschichtfolie (91) zumindest einlagig um den mit der Grundschicht (38) versehenen Aktorkörper (23) gelegt ist.

7. Piezoelektriscches Aktormodul nach Anspruch 6,
**dadurch gekennzeichnet,**
**dass** die Mehrschichtfolie (41) eine Binderschicht (43) aufweist, die zwischen der Isolierfolie (39) und der Metallfolie (40) vorgesehen ist.

8. Piezoelektrisches Aktormodul nach Anspruch 6 oder 7,
**dadurch gekennzeichnet,**
**dass** die Mehrschichtfolie (41) auf zumindest .einer Außenseite eine Klebstoffschicht (42) aufweist.

9. Piezoelektrisches Aktomodul flach Anspruch 8,
**dadurch gekennzeichnet,**
**dass** die Klebstoffschicht (42) auf der Seite der Isolierfolie (39) vorgesehen ist.

10. Brennstoffeinspritzventil (1), insbesondere Injektor für Brennstoffeinspritzanlagen von luftverdichtenden, selbstzündenden Brennkraftmaschinen, mit einem piezoelektrischen Aktormodul (19) nach einem der Ansprüche 1 bis 9 und einem von dem Aktormodul (19) betätigbaren Ventilschlieβkörper (12), der mit einer Ventilsitzfläche (11) zu einem Dichtsitz zusammenwirkt.

## Claims

1. Piezoelectric actuator module (19), in particular actuator module for fuel injection valves, comprising at least one actuator body (23) which has a multiplicity of ceramic layers (26, 27) and a multiplicity of electrode layers (28, 29) arranged between the ceramic layers (26, 27), wherein a base layer (38) at least substantially encompasses an outer face (35) of the actuator body (23), a metal foil (40) is wound around the actuator body (23) provided with the base layer (38) and the base layer (38) and the metal foil (40) are separated from one another by at least one insulating foil (39), **characterized in that** the metal foil (40) has an at least substantially parallelogram-shaped geometry or an at least substantially double parallelogram-shaped geometry.

2. Piezoelectric actuator module (19) according to Claim 1,
**characterized**
**in that** the insulating foil (39) is wound at least in a single ply around the actuator body (23) provided with the base layer (38), and in that the metal foil (40) is wound at least in a single ply around the actuator body (23) around which the insulating foil (39) is wound.

3. Piezoelectric actuator module according to Claim 2,
**characterized**
**in that** the insulating foil (39) is bonded to the metal foil (40) by means of a layer of adhesive (42).

4. Piezoelectric actuator module according to Claim 3,
**characterized**
**in that** the insulating foil (39) is laid directly around the actuator body (23) provided with the base layer (38).

5. Piezoelectric actuator module according to Claim 3 or 4,
**characterized**
**in that** there is no integral bond between the insulating foil (39) and the base layer (38).

6. Piezoelectric actuator module according to Claim 1,
**characterized**
**in that** a multilayer foil (41) which comprises the insulating foil (39) and the metal foil (40) is provided, and in that the multilayer foil (41) is laid at least in a single ply around the actuator body (23) provided with the base layer (38).

7. Piezoelectric actuator module according to Claim 6,
**characterized**
**in that** the multilayer foil (41) has a binder layer (43), which is provided between the insulating foil (39) and the metal foil (40).

8. Piezoelectric actuator module according to Claim 6 or 7,
**characterized**
**in that** the multilayer foil (41) has a layer of adhesive (42) on at least one outer side.

9. Piezoelectric actuator module according to Claim 8,
**characterized**
**in that** the layer of adhesive (42) is provided on the side of the insulating foil (39).

10. Fuel injection valve (1), in particular injector for fuel injection systems of air-compressing, auto-ignition internal combustion engines, comprising a piezoelectric actuator module (19) according to one of Claims 1 to 9 and a valve closing body (12), which can be actuated by the actuator module (19) and interacts with a valve seat face (11) to form a sealing seat.

## Revendications

1. Module d'actionneur piézoélectrique (19), en particulier module d'actionneur pour soupapes d'injection de carburant, comprenant au moins un corps d'actionneur (23) qui comporte une pluralité de couches céramiques (26, 27) et une pluralité de couches d'électrode (28, 29) disposées entre les couches céramiques (26, 27), une couche de base (38) entourant au moins essentiellement une surface extérieure (35) du corps d'actionneur (23), une feuille métallique (40) étant enroulée autour du corps d'actionneur (23) pourvu de la couche de base (38), et la couche de base (38) ainsi que la couche métallique (40) étant séparées l'une de l'autre par au moins une couche isolante (39), **caractérisé en ce que** la feuille métallique (40) présente une géométrie au moins essentiellement en forme de parallélogramme ou une géométrie au moins essentiellement en forme de parallélogramme double.

2. Module d'actionneur piézoélectrique (19) selon la revendication 1,
**caractérisé en ce**
**que** la couche isolante (39) est enroulée au moins en une seule couche autour du corps d'actionneur (23) pourvu de la couche de base (38), et en ce que la couche métallique (40) est enroulée au moins en une seule couche autour du corps d'actionneur (23) autour duquel la couche isolante (39) est enroulée.

3. Module d'actionneur piézoélectrique selon la revendication 2,
**caractérisé en ce**
**que** la couche isolante (39) est connectée à la couche métallique (40) au moyen d'une couche d'adhésif (42).

4. Module d'actionneur piézoélectrique selon la revendication 3,
**caractérisé en ce**
**que** la couche isolante (39) est placée directement autour du corps d'actionneur (23) pourvu de la couche de base (38).

5. Module d'actionneur piézoélectrique selon la revendication 3 ou 4,
**caractérisé en ce**
**qu'**aucune connexion par liaison de matière n'existe entre la couche isolante (39) et la couche de base (38).

6. Module d'actionneur piézoélectrique selon la revendication 1,
**caractérisé en ce**
**qu'**il est prévu une feuille multicouche (41) qui comporte la couche isolante (39) et la couche métallique (40), et en ce que la feuille multicouche (41) est placée au moins en une seule couche autour du corps d'actionneur (23) pourvu de la couche de base (38).

7. Module d'actionneur piézoélectrique selon la revendication 6,
**caractérisé en ce**
**que** la feuille multicouche (41) comporte une couche de liaison (43) qui est prévue entre la couche isolante (39) et la couche métallique (40).

8. Module d'actionneur piézoélectrique selon la revendication 6 ou 7,
**caractérisé en ce**
**que** la feuille multicouche (41) comporte une couche d'adhésif (42) sur au moins un côté extérieur.

9. Module d'actionneur piézoélectrique selon la revendication 8,
**caractérisé en ce**
**que** la couche d'adhésif (42) est prévue du côté de la couche isolante (39).

10. Soupape d'injection de carburant (1), en particulier injecteur pour installations d'injection de carburant de moteurs à combustion interne à autoallumage et à suralimentation, comprenant un module d'actionneur piézoélectrique (19) selon l'une quelconque des revendications 1 à 9 et un corps de fermeture de soupape (12) pouvant être actionné par le module d'actionneur (19), lequel corps de fermeture de soupape coopère avec une surface de siège de soupape (11) de manière à former un siège d'étanchéité.
